(19) Europäisches Patentamt
European Patent Office
Office européen des brevets

(11) **EP 2 547 024 B1**

(12) **EUROPEAN PATENT SPECIFICATION**

(45) Date of publication and mention
of the grant of the patent:
**31.08.2016 Bulletin 2016/35**

(51) Int Cl.:
***H04L 1/00*** *(2006.01)*

(21) Application number: **12155950.4**

(22) Date of filing: **17.02.2012**

(54) **Method for De-Interleaving and Broadcast Receiving Apparatus**

Verfahren zum Entschachteln und Rundfunkübertragungsvorrichtung

Procédé de désentrelacement et appareil de réception de diffusion

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **14.07.2011 KR 20110070108**

(43) Date of publication of application:
**16.01.2013 Bulletin 2013/03**

(73) Proprietor: **Samsung Electronics Co., Ltd.
Suwon-si, Gyeonggi-do, 443-742 (KR)**

(72) Inventors:
• **Kim, Dae-ki
Gyeonggi-do (KR)**
• **Oh, Dae-sun
Gyeonggi-do (KR)**

(74) Representative: **Appleyard Lees IP LLP
15 Clare Road
Halifax HX1 2HY (GB)**

(56) References cited:
**EP-A2- 2 239 855      GB-A- 2 465 611
US-B2- 7 673 225**

• **TAKASHI YOKOKAWA ET AL: "Parity and column twist bit interleaver for DVB-T2 LDPC codes", TURBO CODES AND RELATED TOPICS, 2008 5TH INTERNATIONAL SYMPOSIUM ON, IEEE, PISCATAWAY, NJ, USA, 1 September 2008 (2008-09-01), pages 123-127, XP031353674, DOI: 10.1109/TURBOCODING.2008.4658684 ISBN: 978-1-4244-2862-5**

Description

## BACKGROUND

1. Field

Methods and apparatuses consistent with exemplary embodiments relate to a method for de-interleaving and a broadcast receiving apparatus applying the same, and more particularly, to a method for de-interleaving broadcast data such as according to the digital video broadcasting-terrestrial version 2 (DVB-T2) standard, and a broadcast receiving apparatus applying the same.

2. Description of the Related Art

Thanks to the advancement of electronic and communication technology, digital technology has been adopted in a broadcasting system field and thus diverse standards for digital broadcasting have been announced. More specifically, the American ATSC VSB standard and the European DVB-T standard are representative examples of these standards. The two standards are different from each other in several aspects such as audio compression and channel band. One significant difference is that the ATSC VSB standard adopts a single carrier method, while the DVB-T standard adopts a multi- carrier method.

In particular, the DVB-T technology is an example of a digital terrestrial broadcasting method, and is undergoing research and development for use in all countries of the European Union. DVB-T is based on MPEG-1, 2 systems in order to make video-audio encoding in a DVB system compatible with most of the transmission schemes. The DVB group started a new research project "DVB-T2" in 2006 to establish a next generation terrestrial digital TV standard.

A core aim of the DVB-T2 standard is to increase a transmission rate and make a transmission network robust and reliable. DVB-T2 focuses on transmission of digital TV contents through mobile devices or smooth transmission of broadcast services to vehicles such as subways, trains, and buses. That is, the DVB-T2 project was established in order to improve transmission efficiency and mobile reception performance compared to the existing DVB-T standard, considering generalization of HD service and diversification of mobile applications.

DVB-T2 adopted as new technology a preamble structure, namely distributed multi-input single output (MISO), which has been used previously in mobile communication. MISO is a diversity technology for setting as if two antennas are installed in one base station, a bit interleaver technology in a channel coding, a peak-to-average power ratio (PAPR) reduction technique which uses some carrier for a different purpose, rotated constellation which is a method for rotating during modulation, and 256 QAM.

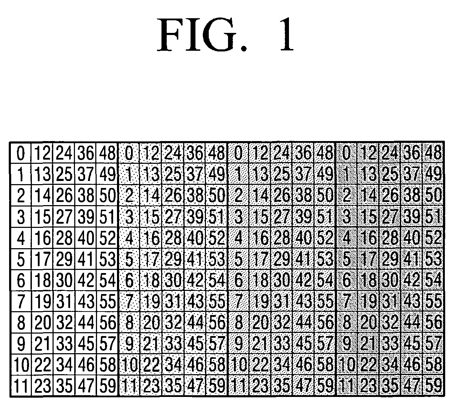

FIGS. 1, 2 and 3 are views to explain a method for de-interleaving as performed by a time de-interleaver and a cell de-interleaver of a related-art receiving apparatus according to the DVB-T2 standard.

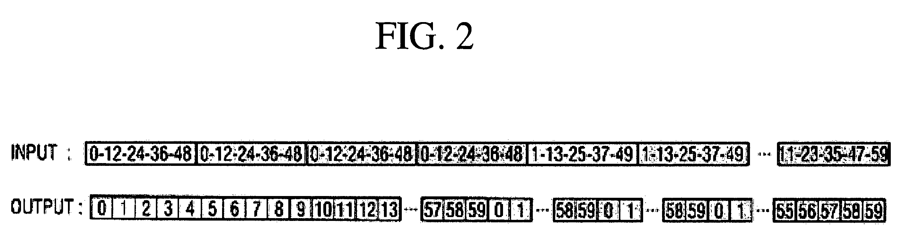

FIG. 1 illustrates image data input to the time de-interleaver, in which 12 cells exist in a row direction and 4 low-density parity-check (LDPC) blocks exist. In this case, a plurality of cells are input to the time de-interleaver in a column direction. That is, as shown in the upper portion of FIG. 2, the plurality of cells are input in order of cell "0" of the first LDPC block, cell "12" of the first LDPC block, cell "24" of the first LDPC block, cell "36" of the first LDPC block, cell "48" of the first LDPC block, cell "0" of the second LDPC block, cell "12" of the second LDPC block, cell "24" of the second LDPC block, cell "36" of the second LDPC block, cell "48" of the second LDPC block, ...and so on.

The plurality of cells input to the time de-interleaver are output in the row direction. That is, as shown in the lower portion of FIG. 2, the plurality of cells are output in order of cell "0" of the first LDPC block, cell "I" of the first LDPC block, cell "2" of the first LDPC block, cell "3" of the first LDPC block, cell "4" of the first LDPC block, cell "5" of the first LDPC block, cell "6" of the first LDPC block, cell "7" of the first LDPC block, cell "8" of the first LDPC block, cell "9" of the first LDPC block,... and so on.

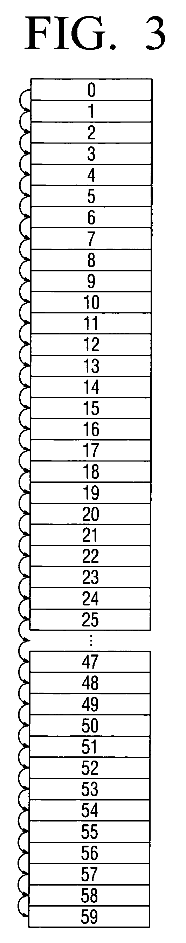

The output cells are re-arranged by a cell de-interleaver in sequence as shown in FIG. 3.

At this time, in order to realize the time de-interleaver using one memory, writing should be performed in a location where reading has been performed. At this time, cell addresses "0, 1, 2, 3, 4,..." are assigned to the cells of the first column and cell addresses "0, c, 2c, 3c, 4c,..." are assigned to the cells of the second column. That is, since a different address is assigned to each of the cells, the memory requires a relatively long time to use the address for every cell in order to process the data and the addresses, and thus, there is a problem in that the number of clock cycles increases.

## SUMMARY

According to the present invention there is provided an apparatus and method as set forth in the appended claims. Other features of the invention will be apparent from the dependent claims, and the description which follows.

One or more exemplary embodiments may overcome the above disadvantages and other disadvantages not described above. However, it is understood that one or more exemplary embodiment are not required to overcome the disadvantages described above, and may not overcome any of the problems described above.

One or more exemplary embodiments provide a method for de-interleaving, which classifies cells of broadcast data into a plurality of groups by grouping the cells in the unit of a multiple of N, where N is a positive integer, performs time de-interleaving in the unit of the group, and performs cell de-interleaving by dividing each of the time de-interleaved groups in the unit of cells, and a broadcast receiving apparatus employing the same.

According to an aspect of an exemplary embodiment, there is provided a method for de-interleaving comprising: receiving broadcast data comprising a plurality of columns each consisting of a plurality of cells arranged in sequence in a number of rows in a row direction, wherein the broadcast data are subdivided into a plurality of low-density parity-check, LDPC, blocks , classifying cells of the broadcast data into a plurality of groups by grouping the cells in a unit of a multiple of N in a column direction, dividing each of the time de-interleaved groups into cells, and performing cell de-interleaving by re-arranging the plurality of cells divided from each group by jumping at a pre-determined interval.

The N is a value that is obtained by dividing a number of cells included in a low-density parity-check (LDPC) block by a number of rows of the LDPC block.

The value ofN may be 5.

The broadcast data comprises a plurality of columns that consist of a plurality of cells arranged in sequence in a row direction, and the classifying comprises grouping the cells of the broadcast data in a unit of N in a column direction.

The performing the time de-interleaving may comprise performing time de-interleaving by outputting the groups in a row direction.

The performing the cell de-interleaving may comprise re-arranging the plurality of cells divided from one group by jumping at a predetermined interval.

The classifying may comprise assigning one address to each of the plurality of groups.

The broadcast data may be broadcast data according to a digital video broadcasting-terrestrial version 2 (DVB-T2) standard.

According to an aspect of another exemplary embodiment, there is provided a broadcast receiving apparatus which receives broadcast data comprising a plurality of columns each consisting of a plurality of cells arranged in sequence in a number of rows in a row direction, wherein the broadcast data are subdivided into a plurality of low-density parity-check, LDPC, blocks, the apparatus comprising: a cell grouping unit that classifies cells of the broadcast data into a plurality of groups by grouping the cells in a unit of a multiple of N in a column direction, a time de-interleaver that performs time de-interleaving in a unit of the group, a cell divider that divides each of the time de-interleaved groups into cells, and a cell de-interleaver that performs cell de-interleaving by re-arranging the plurality of cells divided from each group by jumping at a pre-determined interval.

The N is a value that is obtained by dividing a number of cells included in an LDPC block by a number of rows of the LDPC block.

The N may be 5.

The broadcast data comprises a plurality of columns that consist of a plurality of cells arranged in sequence in a row direction, and the cell grouping unit may group the cells of the broadcast data in a unit of N in a column direction.

The time de-interleaver may perform time de-interleaving by outputting the groups in a row direction.

The cell de-interleaver may re-arrange the plurality of cells divided from the one group by jumping at a pre-determined interval.

The cell grouping unit may assign one address to each of the plurality of groups.

The broadcast data may be broadcast data according to a digital video broadcasting-terrestrial version 2 (DVB-T2) standard.

Additional aspects and advantages of the exemplary embodiments will be set forth in the detailed description, will be obvious from the detailed description, or may be learned by practicing the exemplary embodiments.


## BRIEF DESCRIPTION OF THE DRAWING FIGURES

The above and/or other aspects will be more apparent by describing in detail exemplary embodiments, with reference to the accompanying drawings, in which:

FIGS. 1 to 3 are views to explain related-art time de-interleaving and cell de-interleaving;
FIG. 4 is a block diagram illustrating a broadcast receiving apparatus according to an exemplary embodiment;
FIG. 5 is a block diagram illustrating a de-interleaver according to an exemplary embodiment;
FIGS. 6 to 7 are views to explain time de-interleaving and cell de-interleaving according to an exemplary embodiment (Figure 8 is a related disclosure); and
FIG. 9 is a flowchart illustrating a method for de-interleaving of a broadcast receiving apparatus according to an exemplary embodiment.

## DETAILED DESCRIPTION OF THE EXEMPLARY EMBODIMENTS

Hereinafter, exemplary embodiments will be described in greater detail with reference to the accompanying drawings.

In the following description, same reference numerals are used for the same elements when they are depicted in different drawings. The matters defined in the description, such as detailed construction and elements, are provided to assist in a comprehensive understanding of the exemplary embodiments. Thus, it is apparent that the exemplary embodiments can be carried out without those specifically defined matters. Also, functions or elements known in the related art are not described in detail since they would obscure the exemplary embodiments with unnecessary detail.

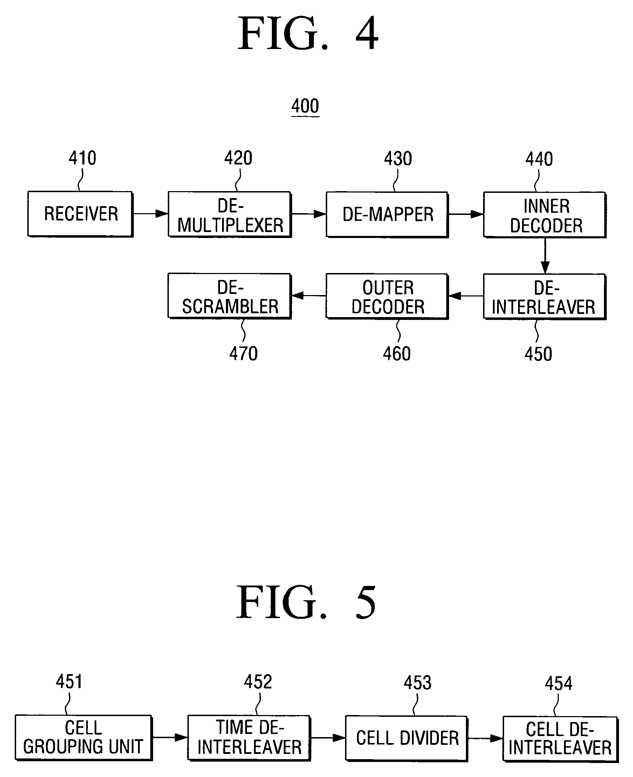

FIG. 4 is a block diagram illustrating a broadcast receiving apparatus according to an exemplary embodiment. As shown in FIG. 4, a broadcast receiving apparatus 400 according to an exemplary embodiment comprises a receiver 410, a de-multiplexer 420, a de-mapper 430, an inner decoder 440, a de-interleaver 450, an outer decoder 460, and a de-scrambler 470.

The receiver 410 receives broadcast data from an external broadcast transmitting apparatus. The receiver 410 may comprise an analog/digital (A/D) converter, a down converter, a discrete Fourier transformer (DFT), and an equalizer. The A/D converter converts OFDM symbol data received through an antenna into analog/digital data and outputs digital OFDM symbol data. The down converter down-converts the symbol output from the A/D converter into a baseband signal. The DFT performs Fourier transformation with respect to the down-converted symbol, and outputs an OFDM symbol of a frequency domain. In this case, the DFT may be realized by a fast Fourier transformer (FFT). The equalizer performs channel equalizing by detecting a pilot symbol from each OFDM symbol.

In particular, the receiver 410 may receive broadcast data according to the DVB-T2 standard. The de-multiplexer 420 de-multiplexes the symbols that configure the OFDM symbol received through the receiver 410, and classifies the symbols so that the symbols of the same priority are grouped.

The de-mapper 430 de-maps the symbols into data bits.

The inner decoder 440 decodes the received data bits by low-density parity-check (LDPC). The inner decoder 440 may be realized by a serial structure, a fully parallel structure or a semi serial structure.

The de-interleaver 450 de-interleaves the LDPC-decoded data bits. The de-interleaver 450 uses a frequency de-interleaver, a time de-interleaver, a cell de-interleaver, and a bit de-interleaver. In particular, the time de-interleaver and the cell de-interleaver to re-arrange the cells distributed from LDPC blocks will be explained in detail with reference to FIG. 5.

The outer decoder 460 decodes the de-interleaved data bits by Bose-Chaudhuri-Hocquenghem (BCH).

The de-scrambler 470 de-randomizes the LDPC-decoded data and restores a data stream.

The receiver 410, the de-multiplexer 420, the de-mapper 430, the inner decoder 440, the de-interleaver 450, the outer decoder 460, and the de-scrambler 470 of FIG. 4 are described in detail in the already published standard documents and thus a detailed description thereof is omitted.

FIG. 5 is a block diagram illustrating the de-interleaver 450 to perform time de-interleaving and cell de-interleaving according to an exemplary embodiment.

As shown in FIG. 5, the de-interleaver 450 comprises a cell grouping unit 451, a time de-interleaver 452, a cell divider 453, and a cell de-interleaver 454.

The cell grouping unit 451 classifies the frequency de-interleaved cells into a plurality of groups by grouping the cells in the unit of a multiple of N.

N is a value that is obtained by dividing the number of cells included in a LDPC block by the number of rows of the LDPC block. In particular, N equals to 5.

More specifically, the number of cells included in the LDPC block and the number of rows are different according to a length of the LDPC block and a modulation mode under the DVB-T2 standard, as shown in table 1 below: [Table 1]

| LDPC block length | | | |
|---|---|---|---|
| ($N_{ldpc}$) | Modulation Mode | Number of cells per LDPC block ($N_{CELL}$) | Number of rows ($N_r$) |
| 64800 | 256-QAM | 8100 | 1620 |
| | 64-QAM | 10800 | 2160 |
| | 16-QAM | 16200 | 3240 |
| | QPSK | 32400 | 6480 |

**EP 2 547 024 B1**

(continued)

| LDPC block length | | | |
|---|---|---|---|
| $(N_{ldpc})$ | Modulation Mode | Number of cells per LDPC block ($N_{CELL}$) | Number of rows ($N_r$) |
| 16200 | 256-QAM | 2025 | 405 |
| | 64-QAM | 2700 | 540 |
| | 16-QAM | 4050 | 810 |
| | QPSK | 8100 | 1620 |

The number of cells included in one LDPC block ($N_{CELL}$) and the number of rows ($N_r$) have the following mathematical relationship:

[Equation 1]

$$\frac{N_{CELL}}{N_R} = 5$$

That is, the number of cells included in one row of the LDPC block is always 5. Accordingly, the cell grouping unit 451 classifies the cells into the plurality of groups by grouping the cells in the unit of a multiple of 5.

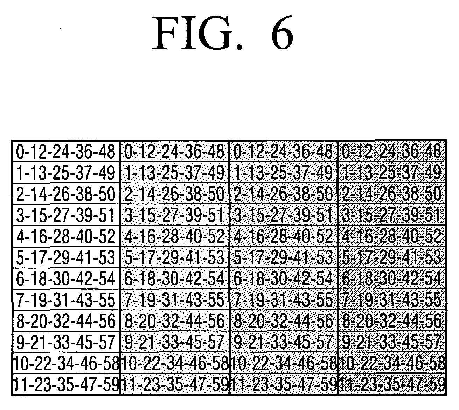

The cell grouping unit 450 may group the plurality of cells in the unit of 5 cells in a column direction. For example, as shown in FIG. 6, the cell grouping unit 451 may classify cells "0", "12", "24", "36", and "48" of a first LDPC block into a first group. Also, the cell grouping unit 451 may classify cells "0", "12", "24", "36", and "45" of a second LDPC block into a second group. In the same way, the cell classifies the plurality of cells by grouping the 5 cells in one group in the column direction.

However, this is merely an example and the cells may be grouped in the unit of a multiple of 5 as described above. For example, the cells may be grouped in the unit of 10 cells.

Each of the groups may be assigned one address. For example, the addresses are assigned in such a way that address "0" is assigned to the first group, address "1" is assigned to the second group, address "2" is assigned to the third group, and so on. However, this is merely an example. Continuous addresses may be assigned to the group. For example, addresses "0", "1", "2", "3", and "4" may be assigned to cells "0", "12", "24", "36", and "48" of the first LDPC block included in the first group, respectively.

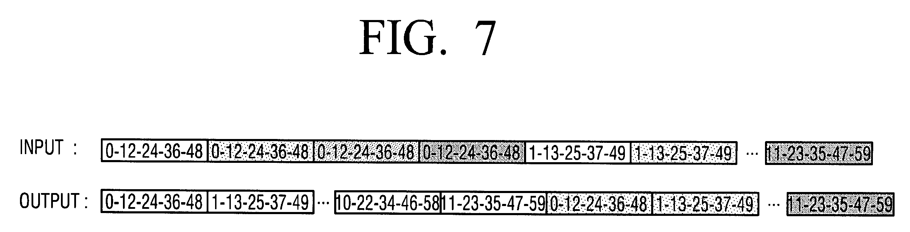

The cells which have been grouped in the unit of a multiple of 5 by the cell grouping unit 451 are input to the time de-interleaver 452 in the column direction. For example, as shown in the upper portion of FIG. 7, the cells are input to the time de-interleaver 452 in order of the first group in which cells "0", "12", "24", "36", and "48" of the first LDPC block are grouped, the second group in which cells "0", "12", "24", "36", and "48" of the second LDPC block are grouped, the third group in which cells "0", "12", "24", "36", and "48" of the third LDPC block are grouped, the fourth group in which cells "0", "12", "24", "36", and "48" of the fourth LDPC block are grouped, the fifth group in which cells "1", "13", "25", "37", and "49" of the first LDPC block are grouped, ..., and so on.

The time de-interleaver 452 outputs the groups input in the column direction in a row direction. For example, as shown in the lower portion of FIG. 7, the time de-interleaver 452 outputs the groups in order of the first group in which cells "0", "12", "24", "36", and "48" of the first LDPC block are grouped, the fifth group in which cell "1", "13", "25", "37", and "49" of the first LDPC block are grouped, the ninth group in which cells "2", "14", "26", "38", and "50" of the first LDPC block are grouped, the thirteenth group in which cells "3", "15", "27", "39" and "51" of the first LDPC block are grouped, ..., and so on.

The cell divider 453 divides the groups output in the row direction. More specifically, the cell divider 453 divides the first group into cells "0", "12", "24", "36", and "48. The cell divider 453 divides the fifth group into cells "1", "13", "25", "37", and "49". In the same way, the cell divider 453 restores the cells to their state prior to the grouping and inputs the cells into the cell de-interleaver 454.

The cell de-interleaver 454 performs cell de-interleaving with respect to the cells divided by the cell divider 453. The cell de-interleaver 454 re-arranges the incoming cells by jumping at a predetermined interval rather than re-arranging the incoming cells in sequence as would be performed by a related-art cell de-interleaver. If the cells have been grouped in the unit of 5 xn, the predetermined interval (I) may be expressed by following equation:

[Equation 2]

$$I=n*N_r$$

That is, if the cells have been grouped in the unit of 5, the predetermined interval (I) corresponds to the number of rows included in the LDPC block, and, if the cells have been grouped in the unit of 10, the predetermined intervals (I) is a value that is obtained by multiplying the number of rows included in the LDPC by 2.

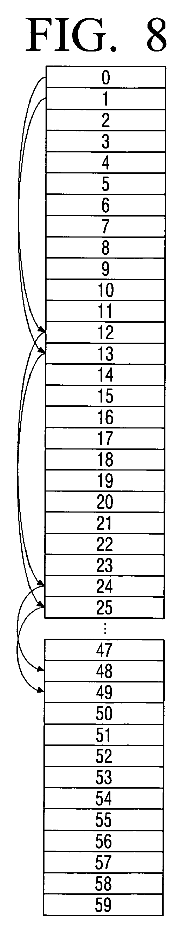

In a related disclosure, if 12 rows are included per LDPC block, the cells may be input to the cell de-interleaver 454 in order of the "0"th cell of the first LDPC block, the 12th cell of the first LDPC block, the 24th cell of the first LDPC block, the 36th cell of the first LDPC block, the 48th cell of the first LDPC block, the 13th cell of the first LDPC block, the 25th cell of the first LDPC block, ... and so on. The cell de-interleaver 454 performs cell de-interleaving by re-arranging the cells by jumping at a predetermined interval (at an interval of 12 cells) rather than re-arranging the cells in sequence, as shown in FIG. 8.

As described above, the time de-interleaving and the cell de-interleaving are performed using the groups grouped in the unit of a predetermined number, so that the number of addresses to be assigned to the cells can be reduced compared to the related-art de-interleaving method. Thus, the number of clock cycles is reduced and a variety of functions can be processed using one memory.

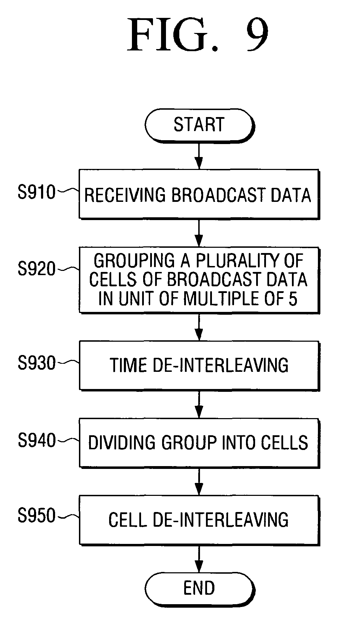

Hereinafter, a method for de-interleaving according to an exemplary embodiment will be explained with reference to FIG. 9. This method may be applied in the broadcast receiving apparatus 400 discussed above.

The broadcast receiving apparatus 400 receives broadcast data from an external broadcast transmitting apparatus (S910). The broadcast data may be broadcast data according to the DVB-T2 standard and may be configured by a plurality of columns consisting of a plurality of cells arranged in sequence in a row direction.

The broadcast receiving apparatus 400 processes the input broadcast data and classifies cells of the broadcast data into a plurality of groups by grouping the cells in the unit of a multiple of 5 prior to performing time de-interleaving (S920). The broadcast receiving apparatus 400 may group the plurality of cells of the broadcast data in a column direction. In particular, the broadcast receiving apparatus 400 may assign one address or continuous addresses to the grouped group.

The broadcast receiving apparatus 400 performs time de-interleaving with respect to the groups (S930). More specifically, the broadcast receiving apparatus performs the time de-interleaving by outputting the groups which have been input in the column direction in a row direction.

The broadcast receiving apparatus 400 divides the groups that have been time de-interleaved (S940). That is, the broadcast receiving apparatus 400 divides the groups in order to restore the groups to the cells prior to the grouping.

The broadcast receiving apparatus 400 performs cell de-interleaving using the divided cells (S950). The broadcast receiving apparatus 400 performs the cell de-interleaving by re-arranging the cells by jumping at a predetermined interval, rather than re-arranging the cells in sequence. The predetermined interval is $n*N_r$($N_r$ is the number of rows included in the LDPC), if the cells have been grouped in the unit of 5*n.

As described above, the time de-interleaving and the cell de-interleaving are performed using the grouped groups so that the number of clocks of a memory is reduced and thus other functions can be performed using the memory used in the de-interleaving.

In the above embodiment, the plurality of cells are grouped in the unit of 5. However, this is merely an example. The technical idea of the present disclosure can be applied to an embodiment in which the cells are grouped in the unit of a multiple of N.

The foregoing exemplary embodiments and advantages are merely exemplary and are not to be construed as limiting the present inventive concept. The exemplary embodiments can be readily applied to other types of apparatuses. Also, the description of the exemplary embodiments is intended to be illustrative, and not to limit the scope of the claims, and many alternatives, modifications, and variations will be apparent to those skilled in the art.

**Claims**

1. A method for de-interleaving, comprising:

   receiving broadcast data (S910) comprising a plurality of columns each consisting of a plurality of cells arranged in sequence in a number of rows in a row direction, wherein the broadcast data are subdivided into a plurality of low-density parity-check, LDPC, blocks;
   classifying cells of the broadcast data into a plurality of groups by grouping the cells (S920) in a unit of a multiple of N in a column direction;

performing time de-interleaving (S930) in a unit of the group;

dividing (S940) each of the time de-interleaved groups into cells; and

performing cell de-interleaving (S950) by re-arranging the plurality of cells divided from each group by jumping at a pre-determined interval,

wherein the N is a value that is obtained by dividing a number of cells included in an LDPC block by a number of rows of the LDPC block.

2. The method as claimed in claim 1, wherein the N is 5.

3. The method as claimed in claims 1 or claim 2, wherein the step of performing time de-interleaving (S930) comprises performing time de-interleaving (S930) by outputting the groups in a row direction.

4. The method as claimed in one of claims 1 to 3, wherein the classifying step comprises assigning one address to each of the plurality of groups.

5. The method as claimed in one of claims 1 to 4, wherein the broadcast data is broadcast data according to a digital video broadcasting-terrestrial version 2 (DVB-T2) standard.

6. A broadcast receiving apparatus (400) which, in use, receives broadcast data (S910) comprising a plurality of columns each consisting of a plurality of cells arranged in sequence in a number of rows in a row direction, wherein the broadcast data are subdivided into a plurality of low-density parity-check, LDPC, blocks, the apparatus comprising:

a cell grouping unit (451) that classifies cells of the broadcast data into a plurality of groups by grouping the cells in a unit of a multiple of N in a column direction;

a time de-interleaver (452) that performs time de-interleaving in a unit of the group;

a cell divider (453) that divides each of the time de-interleaved groups into cells; and

a cell de-interleaver (454) that performs cell de-interleaving by re-arranging the plurality of cells divided from each group by jumping at a pre-determined interval,

wherein the N is a value that is obtained by dividing a number of cells included in an LDPC block by a number of rows of the LDPC block.

7. The broadcast receiving apparatus (400) as claimed in claim 6, wherein the value of N is 5.

8. The broadcast receiving apparatus (400) as claimed in claim 6 or claim 7, wherein the cell grouping unit assigns one address to each of the plurality of groups.

**Patentansprüche**

1. Verfahren zum Entschachteln, umfassend:

Empfangen von Übertragungsdaten (S910), die eine Vielzahl von Spalten umfassen, die jeweils aus einer Vielzahl von Zellen bestehen, die in einer Abfolge in einer Vielzahl von Reihen in einer Reihenrichtung angeordnet sind, wobei die Übertragungsdaten in eine Vielzahl von Paritätsprüfcodeblöcken mit niedriger Dichte (Low-Density Parity-Check blocks, LDPC-Blöcke) unterteilt sind;

Klassifizieren von Zellen der Übertragungsdaten in eine Vielzahl von Gruppen, indem die Zellen in eine Einheit eines Vielfachen von N in einer Spaltenrichtung gruppiert werden (S920);

Ausführen einer Zeitentschachtelung (S930) in einer Einheit der Gruppe;

Teilen (S940) jeder der zeitentschachtelten Gruppen in Zellen; und

Ausführen einer Zellenentschachtelung (S950) durch ein Neuanordnen der Vielzahl von Zellen, die durch das Teilen jeder Gruppe erhalten wurden, indem mit einem vorbestimmten Intervall gesprungen wird,

wobei N ein Wert ist, der durch das Teilen einer Anzahl von in einem LDPC-Block enthaltenen Zellen durch eine Anzahl von in einem LDPC-Block enthaltenen Reihen erhalten wird.

2. Verfahren nach Anspruch 1, wobei N gleich 5 ist.

3. Verfahren nach Anspruch 1 oder Anspruch 2, wobei der Schritt des Ausführens einer Zeitentschachtelung (S930) ein Ausführen einer Zeitentschachtelung (S930) umfasst, indem die Gruppen in einer Reihenrichtung ausgegeben werden.

4.  Verfahren nach einem der Ansprüche 1 bis 3, wobei der Schritt des Klassifizierens ein Zuteilen einer Adresse zu jeder der Vielzahl von Gruppen umfasst.

5.  Verfahren nach einem der Ansprüche 1 bis 4, wobei die Übertragungsdaten Übertragungsdaten gemäß einer Norm eines Antennenfernsehens mit digitaler Videoübertragung (Digital Video Broadcasting-Terrestrial Version 2, DVB-T2) sind.

6.  Übertragungsempfangsvorrichtung (400), die im Betrieb Übertragungsdaten (S910) empfängt, die eine Vielzahl von Spalten umfassen, die jeweils aus einer Vielzahl von Zellen bestehen, die in einer Abfolge in einer Vielzahl von Reihen in einer Reihenrichtung angeordnet sind, wobei die Übertragungsdaten in eine Vielzahl von Paritätsprüfcodeblöcken mit niedriger Dichte (Low-Density Parity-Check blocks, LDPC-Blöcke) unterteilt sind, wobei die Vorrichtung umfasst:

eine Zellengruppierungseinheit (451), welche die Zellen der Übertragungsdaten in eine Vielzahl von Gruppen klassifiziert, indem die Zellen in eine Einheit eines Vielfachen von N in einer Spaltenrichtung gruppiert werden;
eine Zeitentschachtelungseinheit (452), die eine Zeitentschachtelung in einer Einheit der Gruppe ausführt;
einen Zellenteiler (453), der jede der zeitentschachtelten Gruppen in Zellen teilt; und
eine Zellenentschachtelungseinheit (454), die eine Zellenentschachtelung durch ein Neuanordnen der Vielzahl von Zellen ausführt, die durch das Teilen jeder Gruppe erhalten wurden, indem mit einem vorbestimmten Intervall gesprungen wird,
wobei N ein Wert ist, der durch das Teilen einer Anzahl von in einem LDPC-Block enthaltenen Zellen durch eine Anzahl von in einem LDPC-Block enthaltenen Reihen erhalten wird.

7.  Übertragungsempfangsvorrichtung (400) nach Anspruch 6, wobei der Wert N gleich 5 ist.

8.  Übertragungsempfangsvorrichtung (400) nach Anspruch 6 oder Anspruch 7, wobei die Zellengruppierungseinheit jeder der Vielzahl von Gruppen eine Adresse zuteilt.

**Revendications**

1.  Procédé de désentrelacement, comprenant les étapes suivantes:

recevoir des données de diffusion (S910) comprenant une pluralité de colonnes, chacune consistant en une pluralité de cellules disposées en séquence dans un certain nombre de rangées dans une direction de rangée, où les données de diffusion sont subdivisées en une pluralité de blocs de contrôle de parité à faible densité, LDPC ;
classer les cellules des données de diffusion en une pluralité de groupes en regroupant les cellules (S920) dans une unité d'un multiple de N dans une direction de colonne ;
effectuer un désentrelacement temporel (S930) dans une unité du groupe ;
diviser (S940) chacun des groupes ayant subi un désentrelacement temporel en cellules ; et
effectuer un désentrelacement cellulaire (S950) en réarrangeant la pluralité de cellules divisées à partir de chaque groupe en sautant à un intervalle prédéterminé,
où la valeur N est une valeur qui est obtenue en divisant un nombre de cellules incluses dans un bloc LDPC par un nombre de rangées du bloc LDPC.

2.  Procédé tel que revendiqué dans la revendication 1, dans lequel N est égal à 5.

3.  Procédé tel que revendiqué dans la revendication 1 ou la revendication 2, dans lequel l'étape comprenant d'effectuer un désentrelacement temporel (S930) comprend d'effectuer un désentrelacement temporel (S930) en délivrant en sortie les groupes dans une direction de rangée.

4.  Procédé tel que revendiqué dans l'une quelconque des revendications 1 à 3, dans lequel l'étape de classification comprend d'affecter une adresse à chacun de la pluralité des groupes.

**5.** Procédé tel que revendiqué dans l'une quelconque des revendications 1 à 4, dans lequel les données de diffusion sont des données de diffusion selon la norme de diffusion vidéo numérique terrestre version 2 (DVB-T2).

**6.** Appareil de réception de diffusion (400) qui, en utilisation, reçoit des données de diffusion (S910) comprenant une pluralité de colonnes, chacune consistant en une pluralité de cellules disposées en séquence dans un certain nombre de rangées dans une direction de rangée, où les données de diffusion sont subdivisées en une pluralité de blocs de contrôle de parité à faible densité, LDPC, l'appareil comprenant:

une unité de regroupement de cellules (451) qui classe les cellules des données de diffusion en une pluralité de groupes en regroupant les cellules dans une unité d'un multiple de N dans une direction de colonne ;
un dispositif de désentrelacement temporel (452) qui effectue un désentrelacement temporel dans une unité du groupe ;
un diviseur de cellule (453) qui divise chacun des groupes ayant subi un désentrelacement temporel en cellules ; et
un dispositif de désentrelacement cellulaire (454) qui effectue un désentrelacement cellulaire en réarrangeant la pluralité de cellules divisées à partir de chaque groupe en sautant à un intervalle prédéterminé,
où N est une valeur qui est obtenue en divisant un nombre de cellules incluses dans un bloc LDPC par un nombre de rangées du bloc LDPC.

**7.** Appareil de réception de diffusion (400) tel que revendiqué dans la revendication 6, dans lequel la valeur de N est 5.

**8.** Appareil de réception de diffusion (400) tel que revendiqué dans la revendication 6 ou la revendication 7, dans lequel l'unité de regroupement de cellules affecte une adresse à chacun de la pluralité des groupes.

# FIG. 1

# FIG. 2

EP 2 547 024 B1

INPUT : | 0-12-24-36-48 | 0-12-24-36-48 | 0-12-24-36-48 | 0-12-24-36-48 | 1-13-25-37-49 | 1-13-25-37-49 | ··· | 11-23-35-47-59 |

OUTPUT : | 0 | 1 | 2 | 3 | 4 | 5 | 6 | 7 | 8 | 9 | 10 | 11 | 12 | 13 | ··· | 57 | 58 | 59 | 0 | 1 | ··· | 58 | 59 | 0 | 1 | ··· | 58 | 59 | 0 | 1 | ··· | 55 | 56 | 57 | 58 | 59 |

# FIG. 3

# FIG. 4

400

410

**RECEIVER**

420

**DE-MULTIPLEXER**

430

**DE-MAPPER**

440

**INNER DECODER**

470

**DE-SCRAMBLER**

460

**OUTER DECODER**

450

**DE-INTERLEAVER**

# FIG. 5

451

**CELL GROUPING UNIT**

452

**TIME DE-INTERLEAVER**

453

**CELL DIVIDER**

454

**CELL DE-INTERLEAVER**

# FIG. 6

| | | | |
|---|---|---|---|
| 0-12-24-36-48 | 0-12-24-36-48 | 0-12-24-36-48 | 0-12-24-36-48 |
| 1-13-25-37-49 | 1-13-25-37-49 | 1-13-25-37-49 | 1-13-25-37-49 |
| 2-14-26-38-50 | 2-14-26-38-50 | 2-14-26-38-50 | 2-14-26-38-50 |
| 3-15-27-39-51 | 3-15-27-39-51 | 3-15-27-39-51 | 3-15-27-39-51 |
| 4-16-28-40-52 | 4-16-28-40-52 | 4-16-28-40-52 | 4-16-28-40-52 |
| 5-17-29-41-53 | 5-17-29-41-53 | 5-17-29-41-53 | 5-17-29-41-53 |
| 6-18-30-42-54 | 6-18-30-42-54 | 6-18-30-42-54 | 6-18-30-42-54 |
| 7-19-31-43-55 | 7-19-31-43-55 | 7-19-31-43-55 | 7-19-31-43-55 |
| 8-20-32-44-56 | 8-20-32-44-56 | 8-20-32-44-56 | 8-20-32-44-56 |
| 9-21-33-45-57 | 9-21-33-45-57 | 9-21-33-45-57 | 9-21-33-45-57 |
| 10-22-34-46-58 | 10-22-34-46-58 | 10-22-34-46-58 | 10-22-34-46-58 |
| 11-23-35-47-59 | 11-23-35-47-59 | 11-23-35-47-59 | 11-23-35-47-59 |

# FIG. 7

INPUT : | 0-12-24-36-48 | 0-12-24-36-48 | 0-12-24-36-48 | 0-12-24-36-48 | 1-13-25-37-49 | 1-13-25-37-49 | ⋯ | 11-23-35-47-59 |

OUTPUT : | 0-12-24-36-48 | 1-13-25-37-49 | ⋯ | 10-22-34-46-58 | 11-23-35-47-59 | 0-12-24-36-48 | 1-13-25-37-49 | ⋯ | 11-23-35-47-59 |

# FIG. 8

# FIG. 9

```
                    ┌─────────────┐
                    │    START    │
                    └─────────────┘
                           │
                           ▼
S910 ─┤  ┌────────────────────────────────┐
         │    RECEIVING BROADCAST DATA     │
         └────────────────────────────────┘
                           │
                           ▼
S920 ─┤  ┌────────────────────────────────┐
         │   GROUPING A PLURALITY OF       │
         │   CELLS OF BROADCAST DATA       │
         │   IN UNIT OF MULTIPLE OF 5      │
         └────────────────────────────────┘
                           │
                           ▼
S930 ─┤  ┌────────────────────────────────┐
         │      TIME DE-INTERLEAVING       │
         └────────────────────────────────┘
                           │
                           ▼
S940 ─┤  ┌────────────────────────────────┐
         │    DIVIDING GROUP INTO CELLS    │
         └────────────────────────────────┘
                           │
                           ▼
S950 ─┤  ┌────────────────────────────────┐
         │      CELL DE-INTERLEAVING       │
         └────────────────────────────────┘
                           │
                           ▼
                    ┌─────────────┐
                    │     END     │
                    └─────────────┘
```